# EUROPEAN PATENT APPLICATION

(11) **EP 4 709 060 A1**
(43) Date of publication of application: **11.03.2026**
(21) Application number: 25193818.9
(22) Date of filing: 04.08.2025
(51) Int. Cl.: H05K 1/02, H05K 7/14

(54) **STANDOFF-SPRING COMBINATION FITTING FOR THERMAL SOLUTIONS**

(30) Priority: 04.09.2024 US 202418824590
(71) Applicant: INTEL Corporation, Santa Clara, CA 95054 (US)
(72) Inventor: RODRIGUEZ CHACON, Alonso, La Guacima (CR); NAVARRO ALVAREZ, Arturo, San Isidro (CR); KU, Jeff, Taipei (TW)
(74) Representative: Rummler, Felix

(57) **Abstract**

Example fittings that combine standoffs and springs for supporting thermal solutions are disclosed herein. An example electronic device includes a chassis; a substrate; a thermal solution; and a fitting to separate the substrate from the chassis and to separate the thermal solution from the substrate, the fitting including a standoff end and a spring end.

## Description

### BACKGROUND

Electronic devices include thermal solutions to dissipate heat from heat sources such as system-on-chip package dies. Thermal solutions are typically fastened over the package dies, and the thermal solutions can create pressure points on the corners of the package dies.

### BRIEF DESCRIPTION OF THE DRAWINGS

FIG. 1 is a partial cross-sectional view of an example standoff-spring combination fitting in accordance with teachings of this disclosure.
FIG. 2A is an exploded view of a portion of an electronic device and another an example standoff-spring combination fitting in accordance with teachings of this disclosure.
FIG. 2B is an enlarged view of the standoff-spring combination fitting of FIG. 2A.
FIG. 3 illustrates another an example standoff-spring combination fitting in accordance with teachings of this disclosure.
FIG. 4 illustrates another an example standoff-spring combination fitting in accordance with teachings of this disclosure.
FIG. 5A is a cross-sectional view of another an example standoff-spring combination fitting in accordance with teachings of this disclosure.
FIG. 5B is a top view of the standoff-spring combination fitting of FIG. 5A.
FIG. 5C is a partial cross-sectional view of the standoff-spring combination fitting of FIG. 5A assembled on a substrate.
FIG. 5D illustrates an alternative design for the standoff-spring combination fitting of FIG. 5A.
FIG. 6 is partial cross-sectional view of a portion of an electronic device and another an example standoff-spring combination fitting in accordance with teachings of this disclosure.
FIG. 7 is partial cross-sectional view of a portion of an electronic device and another an example standoff-spring combination fitting in accordance with teachings of this disclosure.
FIG. 8A is a schematic illustration of a traditional fastener, vapor chamber, and spring.
FIG. 8B is a schematic illustration of an example fastener and vapor chamber and a portion of an example standoff-spring combination fitting in accordance with teachings of this disclosure.

In general, the same reference numbers will be used throughout the drawing(s) and accompanying written description to refer to the same or like parts. The figures are not necessarily to scale. Instead, the thickness of the layers or regions may be enlarged in the drawings.

### DETAILED DESCRIPTION

Thermal solutions such as heat pipes, heat sinks, plates, pins, fins, vapor chambers, and other heat transfer devices are included in electronic devices to dissipate heat from heat sources. Heat sources include, for example, such as system-on-chip (SoC) package dies that include processing units such as a central processing unit (CPU), a graphics processing unit (GPU), etc.

Thermal solutions are positioned near and can be fastened over the package dies so the thermal solutions can capture heat from the package die and dissipate the heat from the electronic device. When the thermal solutions are fastened to package dies, the thermal solutions may be unevenly loaded and/or create pressure points on the corners of the package dies. The uneven pressure loading and/or concentrated pressure areas risk cracking the thermal solution and/or the package die. Cracked components suffer from increased thermal inefficiency and can have performance implications of the life of the electronic device. Some thermal solutions have an increased thickness and/or include thicker frames to increase stiffness and mitigate the thermal solution bending and warping that could cause high pressure points over the package die. However, thermal solutions with increased thickness are most costly, heavier, and add to the overall z-height of the electronic device.

Examples disclosed herein include a standoff-spring combination mounting feature or fitting. An example standoff-spring fitting includes a first end that includes a standoff. A standoff is a spacer that separates components such as a substrate (e.g., a printed circuit board (PCB)) and a chassis or cover of an electronic device. There are typically many electronical connections on both sides of a PCB, and spacing the PCB off the chassis enables the electronics on the bottom of the PCB to operate without interference. The standoff prevents components from touching each other and/or other conductive surfaces, which prevents electrical short circuiting and supports safe use of the electronic device. In addition, the space created by the standoff enables airflow around the PCB, which helps dissipate heat. Standoffs also operate as fasteners to hold components such as the PCB in place.

Example standoff-spring fittings disclosed herein also include a second end that includes a spring. The spring provides precise and controlled pressure between the thermal solution and the package die or other heat source. The spring spreads tension across the thermal solution. The spring compression generates a counterforce to thermal solution bending. Examples disclosed herein include the spring on the same side of the thermal solution as the heat source. In other words, the springs is an internal attachment mechanism, as opposed to traditional designs that include springs above the thermal solutions on the opposite side of the heat source. In traditional designs with the spring on top of the thermal solution, the compressed spring height is factored into over z-height of the thermal solution and/or electronic device. The compressed spring height is not a z-height factor with the standoff-spring fittings disclosed herein. The standoff-spring fittings disclosed herein use the space between the thermal solution and the substrate (e.g., the PCB) without requiring additional keep out zones with respect to the PCB.

Example standoff-spring fittings disclosed herein enable reduction in the thickness of the thermal solutions. The thinner thermal solutions enable thinner (e.g., reduced z-height) and lighter electronic devices. In addition, examples disclosed herein do not increase the volume and/or footprint of the thermal solution and/or the electronic device. Examples disclosed herein can simplify attachment mechanisms for thermal solution without impacting the effective cooling area of the thermal solution. Examples disclosed herein also improve package die load and pressure distribution on the thermal solutions. The improved pressure distribution reduces localized pressure, risks of bending the thermal solution, and risks of cracking the package die.

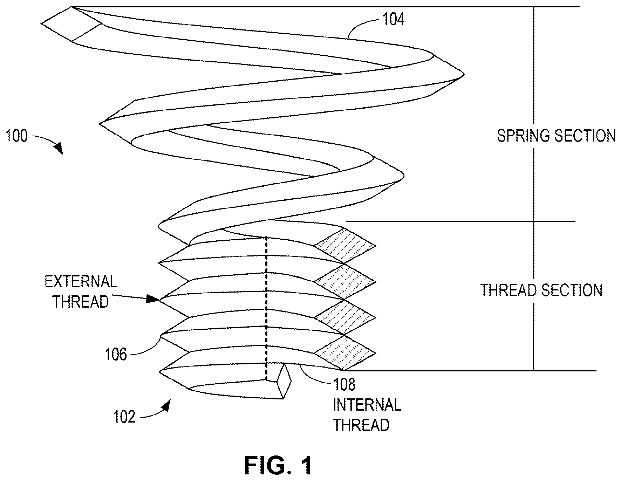

FIG. 1 is a partial cross-sectional view of an example fitting 100, which is combination of a standoff and a spring. Throughout this disclosure, the terms standoff-spring combination fitting, standoff-spring combination, stand-off spring fitting, or simply fitting may be used interchangeably. The fitting 100 includes a first end that forms a standoff 102 and a second end that includes a spring 104. In the illustrated example, the standoff 102 and the spring 104 are integral. In other words, the standoff 102 and the spring 104 are merged into a single part. In some examples, the fitting 100 is made of a single wire. In some examples, the wire that forms the fitting 100 includes a diamond cross-section. Diamond cross-section is more robust than a circular profile.

The standoff 102 has an external thread 106 and an internal thread 108. The external thread 106 is used to couple the standoff 102 to a substrate such as a PCB. The standoff 102 spaces the PCB from other components such as the chassis of the electronic device.

In the illustrated example, the spring 104 is a compression spring and a conical spring. In other examples, other springs including circular coil springs, torsion springs, leaf springs, etc. may be used. When a thermal solution is supported on the fitting 100, compression of the spring 104 generates a counterforce to bending of the thermal solution. With the counterforce, thinner thermal solutions can be used without a risk of cracking the package die and/or of impact to thermal performance.

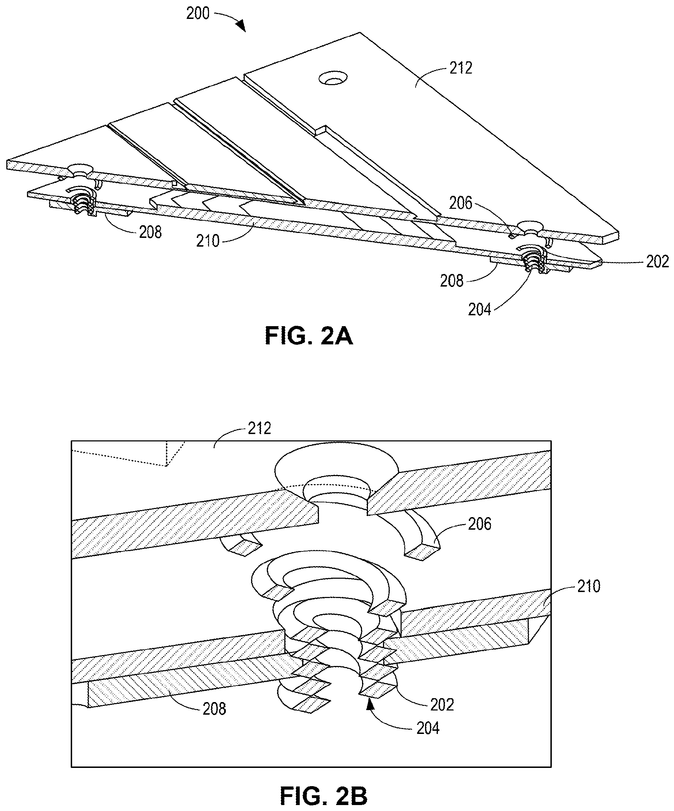

FIG. 2A is an exploded view of a portion of an example electronic device 200 and another an example standoff-spring combination or fitting 202. FIG. 2B is an enlarged view of the fitting 202 of FIG. 2A. The fitting 202 may include features of the fitting 100 of FIG. 1. For example, the fitting 202 includes a standoff 204 and a spring 206. In the example of FIGS. 2A and 2B, the fitting 202 includes an example backplate 208. The threads of the standoff 204 secure the standoff 204 in complementary threads in the backplate 208.

The electronic device 200 includes a substrate or PCB 210. In some examples, the threads of the standoff 204 secure the standoff 204 in complementary threads in the substrate 210. The standoff 202 couples the backplate 208 and the substrate 210. The backplate 208 supports the substrate 210.

The electronic device 200 also includes an example thermal solution 212. The thermal solution 212 is supported by the spring 206. The spring 206 supports the thermal solution 212 from underneath or from the same side of the thermal solution 212 as the substrate 210. A heat source such as a die package also is positioned in the space between the substrate 210 and the thermal solution 212. In some examples, the backplate 208 provides additional heat dissipation capacity.

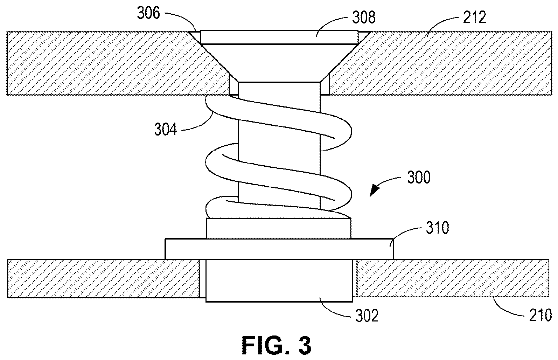

FIG. 3 illustrates another an example standoff-spring combination or fitting 300. The fitting 300 includes a standoff 302 and a spring 304. The standoff 302 supports the substrate 210. The spring 304 supports the thermal solution 212. The thermal solution 212 includes an aperture 306 through which a fastener 308 extends to secure the thermal solution 212 to the fitting 300 and the substrate 210. In the illustrated example, the fastener 308 extends through a center of the fitting 300 in the middle of the coils of the spring 304 and into internal threads (e.g., the internal threads 108) of the standoff 302. Compression of the spring 304 occurs under the thermal solution 212 in the space between the thermal solution 212 and the substrate 210. The spring 304 surrounds the aperture 306 from below (i.e., in the internal space between the thermal solution 212 and the substrate 210).

In some examples, the spring 304 and the standoff 302 are welded together. In some examples, the spring 304 has a larger diameter than the diameter of the standoff 3202. In the example of FIG. 3, the fitting 300 includes an example soldered surface or flange stopper 310 where the spring 304 is welded to the standoff 302 and, in some examples, the standoff 302 is welded to the substrate 210. The flange stopper 310 also prevents the fitting 300 from loosening. In addition, the flange stopper 310 distributes the load from the fitting 300 over a larger area. In the illustrated example, the flange stopper 310 is positioned between the substrate 210 and the thermal solution 212.

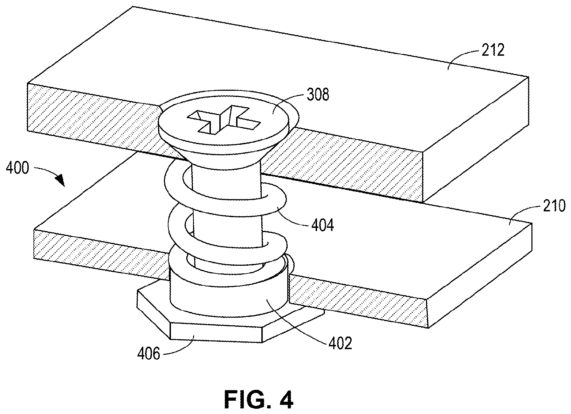

FIG. 4 illustrates another an example standoff-spring combination fitting 400. Like the fitting 300 of FIG. 3, the fitting 400 of FIG. 4 includes a standoff 402, a spring 404 and a stopper flange 406. The stopper flange 406 of the fitting 400 is positioned beneath the substrate 210, in the space between the cover or chassis of the electronic device and the substrate 210. In some examples, the spring 404 has a diameter similar to the diameter of the standoff 402. In such examples, the spring 404 can be mounted from a secondary side through the substrate 210. For example, the spring 404 can be welded or press-fit with the standoff 402. In some examples, the flange stopper 406 holds the spring 404 and standoff 402 together.

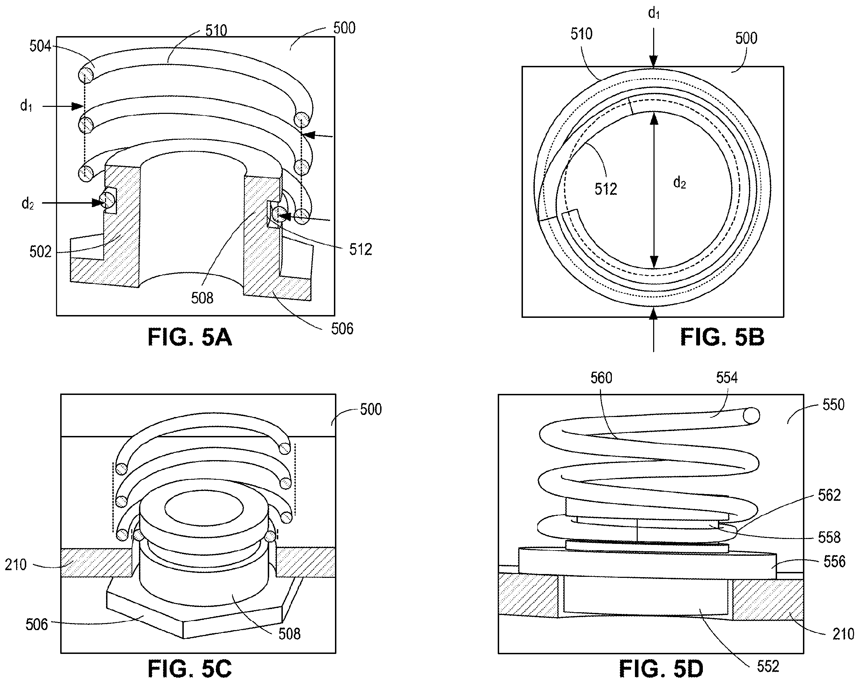

FIG. 5A is a cross-sectional view of another an example standoff-spring combination fitting 500. The fitting 500 includes a standoff 502, a spring 504, and a flange stopper 506. The standoff 502 include an example notch or detent 508. The spring 504 includes a first portion 510 having a first diameter d1 and a second portion 512 having a second diameter d2. The second diameter d2 is smaller than the first diameter d1. The diameters also are illustrated in the top view of the fitting 500 shown in FIG. 5B. The second portion 512 of the spring 504 with the smaller diameter snaps into the detent 508 to hold the spring 504 to the standoff 502. FIG. 5C shows the fitting 500 assembled on the substrate 210. In this example, the stopper flange 506 is positioned beneath the substrate 210, in the space between the cover or chassis of the electronic device and the substrate 210.

FIG. 5D illustrates another an example standoff-spring combination fitting 550. The fitting 550 includes a standoff 552, a spring 554, and a flange stopper 556. The standoff 552 include an example notch or detent 558. The spring 554 includes a first portion 560 having a first diameter and a second portion 562 having a second diameter. The second diameter is smaller than the first diameter. The second portion 562 of the spring 554 with the smaller diameter snaps into the detent 558 to hold the spring 554 to the standoff 552. In the illustrated example, the standoff 552 is welded to the substrate 210, where the flange stopper 556 also forms a soldered surface. In this example, the stopper flange 506 is positioned in the space between the substrate 210 and the thermal solution.

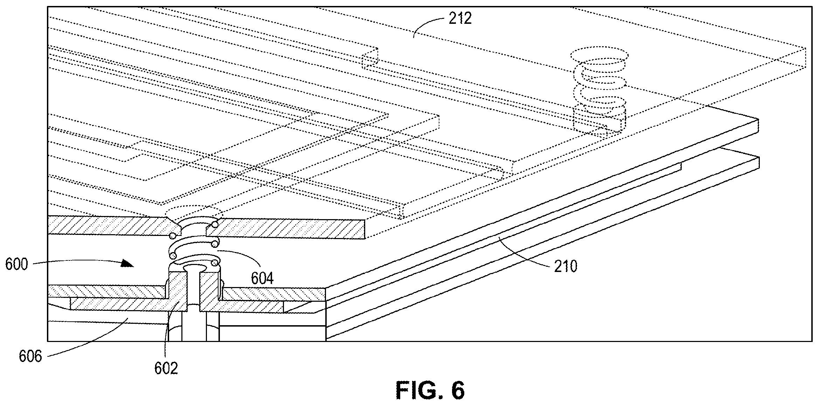

FIG. 6 is partial cross-sectional view of a portion of an electronic device and another an example standoff-spring combination fitting 600. The fitting 600 is similar to the fitting 200. In the example of FIG. 6, the fitting 600 includes a standoff 602, a spring 604 welded to the standoff 602, and a backplate 606 welded to the standoff 602. The spring 604 is welded to the standoff 602 on a first side of the substrate 210, and the backplate 606 is welded to the standoff 602 on a second side of the substrate 210.

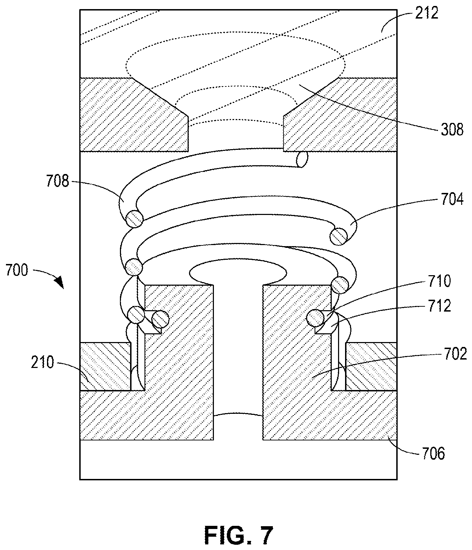

FIG. 7 is partial cross-sectional view of a portion of an electronic device and another an example standoff-spring combination fitting 700. The fitting 700 is similar to the fittings 500, 550 with the snap-fit springs. In the example of FIG. 7, the fitting 700 includes a standoff 702, a spring 7 snap-fit to the standoff 702, and a backplate 706 welded to the standoff 702. The spring 704 is snap fit to the standoff 702 on a first side of the substrate 210, and the backplate 706 is welded to the standoff 702 on a second side of the substrate 210. The spring 704 includes a first portion 708 having a first diameter and a second portion 710 having a second diameter. The second diameter is smaller than the first diameter. The second portion 710 of the spring 700 with the smaller diameter snaps into a detent 712 on the standoff 702 to hold the spring 704 to the standoff 702.

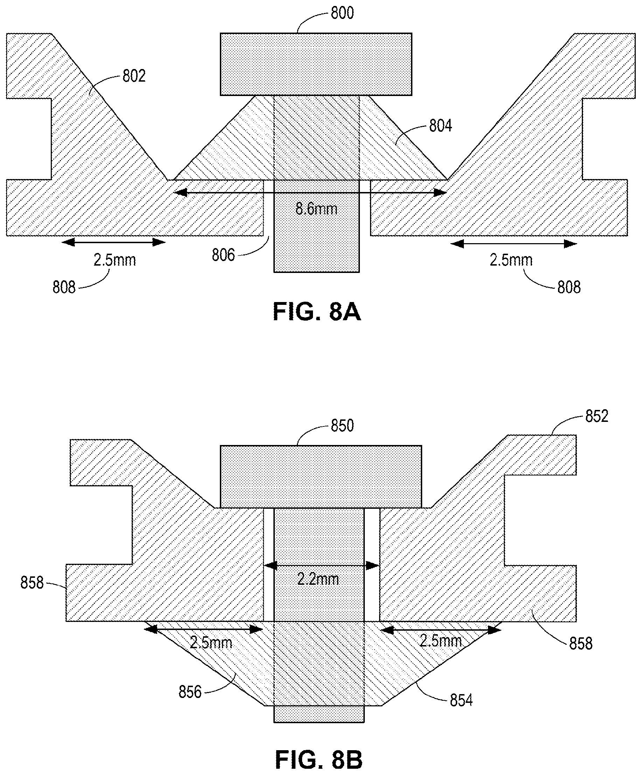

FIG. 8A is a schematic illustration of a traditional fastener 800, vapor chamber 802, and spring 804. In the example of FIG. 8A, the spring 804 is mounted around the fastener 800 around an aperture 806 of the vapor chamber 802 from the top-side of the vapor chamber 802. When the top-side spring-loaded screws are tightened, the spring 804 is typically compressed up to 60-70% of the total length (so not fully compressed). When the spring 804 is not fully compressed, there are openings within the spring coils where some radio frequency leakage may occur through the aperture 806. Radio frequency leakage from operation of the package can affect the effectiveness of electromagnet interference and/or radio frequency interference (EMI/RFI) shields.

In addition, the mounting area for the fastener 800 includes the diameter of the spring 806, which in this example is 8.6 millimeters (mm). The mounting area also includes a vapor chamber connection area 808 on each side of the aperture 806. The vapor chamber connection area 808 corresponds to the lateral distance associated with the recess depth of the fastener 800. In this example, the vapor chamber connection area is 2.5 mm. The area taken by the mounting of the faster 800 is an ineffective area for providing cooling capacity. This area is a circular area defined by πr². The radius, r, is half of the diameter of the spring 804 diameter and the vapor chamber connection areas 808. Thus, in the example of FIG. 8A, the ineffective area taken by a single mounting hole (aperture 806) with spring-loaded fastener 800 is 145 square millimeters (mm²).

FIG. 8B is a schematic illustration of an example fastener 850, vapor chamber 852, and spring 854. In the example of FIG. 8B, the spring 854 is mounted around the fastener 850 around an aperture 856 of the vapor chamber 802 from the bottom-side of the vapor chamber 852. Regardless of the amount of compression of the spring 854 when the vapor chamber 852 is assembled (e.g., to the substrate 210), the fastener 850 covers and seals the aperture 856 to prevent radio frequency leakage through the aperture 806.

In addition, the mounting area for the fastener 850 is smaller than in traditional designs such as that shown in FIG. 8A. The diameter of the spring 856 when mounted from below the vapor chamber 852 is not a factor in the mounting area and ineffective cooling area. The mounting area includes the diameter of the aperture, which is 2.2 mm in this example. The mounting area also includes a vapor chamber connection area 858 on each side of the aperture 806. In this example, the vapor chamber connection area is 2.5 mm. The area taken by the mounting of the faster 850 is a circular area defined by πr². The radius, r, is half of the diameter of the aperture 856 and the vapor chamber connection areas 858. Thus, in the example of FIG. 8B, the ineffective area taken by a single mounting hole (aperture 806) with spring-loaded fastener 850 is 40 mm². Thus, in the example of FIG. 8B, the performance of the vapor chamber 852 is enhanced because larger ineffective cooling areas are not needed to mount than vapor chamber 852 compared to the vapor chamber 802 of FIG. 8A.

Examples disclosed herein describe one fitting that is used to couple or support a thermal solution in an electronic device. In some examples, there may be more than one fittings including for example, two, three, four, etc., to coupled thermal solutions in electronic device.

In some examples, the standoff of the fittings is welded or otherwise electrically connected to the substrate (e.g., PCB). In such examples, the standoff can be used to ground the substrate. The grounded substrate also enhanced the effectiveness of EMI/RFI shields.

The features of examples disclosed herein including, for example, the structure and/or functions of the fittings can be used and/or combined with any other feature of any other example disclosed herein. Examples disclosed herein allow for thinner thermal solutions and electronic devices with decreased z-height and less weight. The thinner thermal solutions also enable the use of larger air gaps around components of the electronic device. The larger air gaps enhance cooling capability and can lower skin temperature of the electronic device. Examples disclosed herein reduce localized pressure on thermal solutions and packages dies, which reduces the risks of bending and cracking. Examples disclosed herein do not use additional countersinks to contain and hide spring-loaded screws, which add weight and complexity to the electronic device.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

Example fittings that combine standoffs and springs for supporting thermal solutions are disclosed herein. Example 1 includes an electronic device that includes a chassis; a substrate; a thermal solution; and a fitting to separate the substrate from the chassis and to separate the thermal solution from the substrate, the fitting including a standoff end and a spring end.

Example 2 includes the electronic device of Example 1, wherein the standoff end and the spring end are soldered.

Example 3 includes the electronic device of Example 1, wherein the standoff end and the spring end are formed from a single wire.

Example 4 includes the electronic device of Example 3, wherein the wire has a diamond cross-section.

Example 5 includes the electronic device of any of Examples 1-4, wherein the standoff end includes a flange stopper.

Example 6 includes the electronic device of Example 5, wherein the flange stopper is between the substrate and the chassis.

Example 7 includes the electronic device of Example 5, wherein the flange stopper is between the substrate and the thermal solution.

Example 8 includes the electronic device of any of Examples 1 or 5-7, wherein the standoff end includes a detent, and the spring end snap fits in the detent.

Example 9 includes the electronic device of Examples 1-8, wherein the spring end has a first diameter at a first end, and second diameter at a second end, the second diameter smaller than the first diameter.

Example 10 includes the electronic device of Examples 1-9, further including a backplate, the fitting coupling the substrate and the backplate.

Example 11 includes the electronic device of Example 10, wherein the standoff end is welded to the backplate.

Example 12 includes the electronic device of any of Examples 1-11, wherein the substrate includes a printed circuit board, and the fitting grounds the printed circuit board.

Example 13 includes an electronic device that includes a chassis; a printed circuit board; a thermal solution; and an integral standoff and spring extending through the printed circuit board to support the printed circuit board off the chassis and to support the thermal solution a distance from the printed circuit board.

Example 14 includes the electronic device of Example 13, wherein the integral standoff and spring are formed from a wire with a diamond cross-section.

Example 15 includes the electronic device of any of Examples 13-14, further including a fastener to couple the thermal solution with the integral standoff and spring.

Example 16 includes the electronic device of Example 15, wherein the thermal solution includes an aperture, the fastener extending through the aperture, and the integral standoff and spring surrounding the aperture between the thermal solution and the printed circuit board.

Example 17 includes the electronic device of any of Examples 13-16, wherein the integral standoff and spring includes a spring that has a first diameter at a first end and second diameter at a second end, the second diameter smaller than the first diameter.

Example 18 includes the electronic device of Example 17, wherein the first end supports the thermal solution.

Example 19 includes the electronic device of any of Examples 13-18, further including a backplate, the integral standoff and spring extending from the backplate through the printed circuit board.

Example 20 includes the electronic device of any of Examples 13-19, wherein the integral standoff and spring is a first integral standoff and spring, the electronic device including a second integral standoff and spring extending through the printed circuit board to support the printed circuit board off the chassis and to support the thermal solution the distance from the printed circuit board.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An electronic device comprising:
a chassis;
a substrate;
a thermal solution; and
a fitting to separate the substrate from the chassis and to separate the thermal solution from the substrate, the fitting including a standoff end and a spring end.

2. The electronic device of claim 1, wherein the standoff end and the spring end are soldered.

3. The electronic device of claim 1, wherein the standoff end and the spring end are formed from a single wire.

4. The electronic device of claim 3, wherein the wire has a diamond cross-section.

5. The electronic device of any of claims 1-4, wherein the standoff end includes a flange stopper.

6. The electronic device of claim 5, wherein the flange stopper is at least one of between the substrate and the chassis or between the substrate and the thermal solution.

7. The electronic device of any of claims 1-6, wherein the standoff end includes a detent, and the spring end snap fits in the detent.

8. The electronic device of any of claims 1-7, wherein the spring end has a first diameter at a first end, and second diameter at a second end, the second diameter smaller than the first diameter.

9. The electronic device of any of claims 1-8, further including a backplate, the fitting coupling the substrate and the backplate.

10. The electronic device of any of claims 1-9, wherein the substrate includes a printed circuit board, and the fitting grounds the printed circuit board.

11. The electronic device of claim 10, wherein the standoff and spring are integral and extend through the printed circuit board to support the printed circuit board off the chassis and to support the thermal solution a distance from the printed circuit board.

12. The electronic device of claim 11, further including a fastener to couple the thermal solution with the integral standoff and spring, wherein the thermal solution includes an aperture, the fastener extending through the aperture, and the integral standoff and spring surrounding the aperture between the thermal solution and the printed circuit board.

13. The electronic device of claim 8, wherein the first end of the spring supports the thermal solution.

14. The electronic device of any of claims 11-13, further including a backplate, the integral standoff and spring extending from the backplate through the printed circuit board.

15. The electronic device of any of claims 11-14, wherein the integral standoff and spring is a first integral standoff and spring, the electronic device including a second integral standoff and spring extending through the printed circuit board to support the printed circuit board off the chassis and to support the thermal solution the distance from the printed circuit board.
